# EUROPÄISCHE PATENTSCHRIFT

(11) **EP 1 841 565 B1**
(45) Veröffentlichungstag und Bekanntmachung des Hinweises auf die Patenterteilung: **04.11.2009**
(21) Anmeldenummer: 05825260.2
(22) Anmeldetag: 20.12.2005
(51) Int. Cl.: B25B 11/00

(54) **VORRICHTUNG ZUM FIXIEREN EINES FLÄCHIGEN OBJEKTS, INSBESONDERE EINES SUBSTRATS AUF EINER ARBEITSFLÄCHE MITTELS UNTERDRUCK**
DEVICE FOR FIXING A FLAT OBJECT, IN PARTICULAR A SUBSTRATE, TO A WORK SURFACE BY MEANS OF LOW PRESSURE
DISPOSITIF POUR FIXER UN OBJET PLAT, EN PARTICULIER UN SUBSTRAT SUR UNE SURFACE DE TRAVAIL A L'AIDE D'UNE DEPRESSION

(30) Priorität: 27.12.2004 CH 215504
(43) Veröffentlichungstag der Anmeldung: 10.10.2007
(73) Patentinhaber: Kulicke & Soffa Die Bonding GmbH, 8572 Berg TG (CH)
(72) Erfinder: SCHUSTER, Johannes, 78462 Konstanz (DE)
(86) Internationale Anmeldenummer: PCT/EP2005/056982
(87) Internationale Veröffentlichungsnummer: WO 2006/069942

(56) Entgegenhaltungen:
- EP-A- 0 706 210
- EP-A- 1 132 948
- EP-A- 1 458 019
- DD-A1- 252 707
- US-A- 4 541 717
- US-A- 5 324 012
- US-A- 5 575 549
- US-A- 6 032 997
- US-A1- 2003 042 889
- US-B1- 6 182 957
- US-B1- 6 203 082

## Beschreibung

Die Erfindung betrifft eine Vorrichtung zum Fixieren eines flächen Objekts, insbesondere eines Substrats auf einer Arbeitsfläche mittels Unterdruck gemäss dem Oberbegriff von Anspruch 1, die aus der Druckschrift US 6032997 bekannt ist.

Derartige Vorrichtungen, auch Frameauflage ("vacuum chuck") genannt, dienen vor allem in der Halbleiterindustrie dazu, ein Substrat für einen bestimmten Bearbeitungsprozess präzise zu fixieren und relativ zu einem Arbeitswerkzeug zu positionieren. So müssen beispielsweise bei der Herstellung von Halbleiterbauelementen mit Hilfe der so genannten Die Bonder die bereits vollständig verarbeiteten Siliciumchips von einem Wafer abgenommen und präzise auf ein Leadframe oder Strip aufgesetzt und dauernd mit diesem Substrat verbunden werden. Zur Einhaltung einer hohen Platziergenauigkeit und für andere Zwecke ist ein Bildverarbeitungssystem vorgesehen, mit dessen Hilfe die Zielabsetzposition des Chips anhand von Markierungen auf dem Substrat ermittelt werden kann. Das Bildverarbeitungssystem kann aber zusätzlich auch noch der Inspektion des Arbeitsbereichs vor und nach dem Absetzen des Chips dienen.

Die Markierungen für die Zielabsetzposition können sich auf der zu bestückenden Seite oder aber auch auf der Rückseite des Substrates befinden. Im ersten Fall ist das Problem der Bilderkennung sehr einfach zu lösen, weil eine Fixierung des Substrates mittels eines "vacuum chucks" von der einen Seite, und sowohl eine Auflichtbeleuchtung und die Bilderkennung als auch die Bestückung von der anderen Seite erfolgen kann. Im Falle der rückseitigen Lage der Markierungen (also bei der dem Bildverarbeitungssystem abgewandten Lage) ist einerseits eine Lichtwellenlänge zu wählen bei der die Substrate eine bestimmte Mindest-Transparenz aufweisen. Andererseits ist bei Verwendung einer Auflichtbeleuchtung in Kombination mit den heute typischerweise verwendeten "vacuum chucks" wegen des zweimaligen Durchgangs durch das Substrat und der rückseitigen Reflexion an den Markierungen mit einer reduzierten Bildqualität und damit Plaziergenauigkeit zu rechnen.

Durch die US 6 032 997 ist ein "vacuum chuck" bekannt geworden, bei welchem die Auflageplatte aus einem giessbaren Glaskörper besteht, dessen Oberfläche eine aus mehreren Abschnitten bestehende ebene Stützstruktur aufweist. Auf der Rückseite der Auflageplatte ist eine reflektierende Schicht angeordnet, sodass ein über der Vorrichtung angeordnetes optisches Positioniersystem Positioniermarken auf der Rückseite eines auf der Auflageplatte liegenden Wafers erkennen kann. Eine derartige Vorrichtung eignet sich jedoch nicht für die Verarbeitung von Substraten, welche die Arbeitsfläche vollständig bedecken, wie dies z.B. bei einem Die Bonding typisch ist.

Es ist daher eine Aufgabe der Erfindung die vorstehend genannten Nachteile zu vermeidet und eine Vorrichtung der eingangs genannten Art zu schaffen, bei welcher für die erforderlichen Bildverarbeitungssysteme eine bessere Bildqualität auch im Falle von rückseitiger Lage der Positionsmarken erzielt wird.

Diese Aufgabe wird erfindungsgemäss mit einer Vorrichtung gelöst, welche die Merkmales Anspruch 1 aufweist. Die Anordnung einer Lichtquelle, deren Strahlengang in die Auflageplatte einspeisbar ist, bewirkt, dass das Substrat homogen im Durchlicht beleuchtet wird, sodass rückseitige Positionsmarken mit dem Bildverarbeitungssystem besser erkennbar sind. Eine Durchlichtbeleuchtung bietet in jedem Fall ein besseres Signal zu Rausch Verhältnis für Positionsmarken, die an sich intransparent sind. Die flächige homogene Beleuchtung von unten ermöglicht es aber auch, den Bereich über der Arbeitsfläche vollständig von Lichtquellen freizuhalten, womit mehr Raum zur Verfügung steht. Dies ermöglicht beispielsweise, dass eine Kamera und eine Pickvorrichtung problemlos auf der gleichen Seite des Substrats angeordnet werden können. Die Unterdruckkanäle sorgen für eine stabile Fixierung des auf der Arbeitsfläche liegenden Objekts, was im Falle eines Halbleitersubstrats besonders wichtig ist.

Die erfindungsgemässe Vorrichtung eignet sich besonders vorteilhaft für den Einsatz in einem Die Bonder. Aber auch andere Einsatzmöglichkeiten sind ohne weiteres denkbar wie z.B. in der Textilindustrie, in der Papierindustrie oder in andere Bereichen, bei denen ein flächiges Objekt unter Einsatz eines Bildverarbeitungssystems verarbeitet werden muss. In der Halbleiterindustrie ergeben sich zusätzliche Anwendungsmöglichkeiten z.B. beim Aufbau von Bauteilen, bei denen das Substrat aus einem dünnen Kunststoffilm besteht oder bei Bauteilen, bei denen zwei oder mehr Chips übereinander geschichtet werden, wobei mit Hilfe der erfindungsgemässen Vorrichtung der erste Chip und/oder das Substrat zur Ausrichtung des zweiten Chips auf den ersten durchleuchtet werden können. Schliesslich ist es aber auch noch denkbar, die homogene Beleuchtung der Arbeitsfläche zur Beleuchtung eines Picktools einzusetzen, um so die Position eines Chips am Tool zu ermitteln.

Eine mit der Arbeitsfläche in Wirkverbindung stehende Beizvorrichtung ermöglicht zusätzlich ein Erwärmen der Arbeitsfläche. Das Substrat wird somit auf seiner Unterseite gleichzeitig mit Licht und mit Wärme beaufschlagt.

Vorzugsweise besteht die Auflageplatte aus Glaskeramik. Es kann sich dabei aber auch um Quarzglas oder unter bestimmten Voraussetzungen auch um ein anderes glasartiges Material handeln.

Die reflektierende Struktur auf der Rückseite der Auflageplatte dient zur Umlenkung des Lichts in Richtung Substrat. Die Strukturen bewirken eine kontrollierte, durch deren Form und Dichte einstellbare Auskopplung von Licht aus der Platte in vertikaler Richtung. Die Struktur kann beispielsweise durch Vertiefungen realisiert werden, welche gegen die Arbeitsfläche gerichtet sind. Es kann sich dabei um eine pyramidenartige, kegelförmige, napfartige oder streifenartige Struktur handeln. Die Vertiefungen müssen dabei nicht zwingend homogen über die Fläche verteilt sein. Je nach der Konfiguration der Auflageplatte bzw. nach Art und Anzahl der eingesetzten Lichtquellen kann eine inhomogene Verteilung der Vertiefungen oder auch eine unterschiedliche Konfiguration der Vertiefungen eingesetzt werden, um eine möglichst homogene Verteilung des Lichts auf der Arbeitsfläche zu erzielen.

Besonders vorteilhaft liegt die Auflageplatte auf einer Plattenbasis auf. Dabei kann die Auflageplatte lösbar mit der Plattenbasis verbunden sein oder sie kann auch mit dieser verklebt sein. Die lösbare Befestigung hat den Vorteil, dass die Auflageplatte auch auf allen Seiten gereinigt werden kann und dass bei Beschädigung die Auflageplatte kostengünstig ausgetauscht werden kann. Desweiteren ist auch eine leichtere Anpassung an ein anderes zu verarbeitendes Produkt möglich. Schliesslich kann die Plattenbasis ihrerseits lösbar auf einem Sockel aufliegen, wobei eine Heizvorrichtung im Sockel angeordnet sein kann. Die Wärmeübertragung erfolgt dabei vom Sockel auf die Plattenbasis und von dort in die Auflageplatte. Die lösbare Anordnung der Plattenbasis hat den Vorteil, dass auf den heizbaren Sockel auch konventionelle Frameauflagen aufgesetzt werden können, die ohne Beleuchtung lediglich beheizt und/oder mit einer Unterdruckversorgung verbunden werden müssen.

Die strahlungsreflektierende Struktur muss nicht zwingend oder nicht ausschliesslich auf der Rückseite der Auflageplatte angeordnet sein. Wenn die Auflageplatte auf einer Plattenbasis aufliegt ist es auch denkbar, dass die Oberfläche der Plattenbasis eine entsprechende Struktur beispielsweise in der Form von Vertiefungen aufweist. In diesem Fall müssen die Vertiefungen allerdings zur Brechungsindex-Adaption mit einem geeigneten Material aufgefüllt werden. Auch eine Kombination von Strukturen auf der Plattenbasis bzw. auf der Rückseite der Auflageplatte wäre denkbar.

In bestimmten Fällen ist es denkbar, dass die Auflageplatte mit einer heizbaren Beschichtung versehen ist. Eine derart elektrisch heizbare Beschichtung kann derart dünn ausgebildet sein, dass die Durchstrahlung des Substrats nicht oder nur unwesentlich beeinträchtigt wird. Der Vorteil der heizbaren Beschichtung liegt jedoch darin, dass die Wärmezufuhr besser und schneller gesteuert werden kann.

Die Lichtquelle kann seitlich der Auflageplatte etwa auf der Höhe zwischen der Arbeitsfläche und der strahlungsreflektierenden Schicht angeordnet sein. Diese Anordnung gewährleistet einen optimalen Effekt der strahlungsreflektierenden Struktur auf der Rückseite der Auflageplatte. In bestimmten Fällen kann es aber auch vorteilhaft sein, wenn die Strahlung der Lichtquelle über wenigstens einen Lichtwellenleiter auf der Seite der Auflageplatte in einer Ebene zwischen der Arbeitsfläche und der strahlungsreflektierenden Struktur in die Auflageplatte einspeisbar ist. Die Lichtquelle kann auf diese Weise örtlich an eine Stelle verlegt werden, wo bessere Platzverhältnisse herrschen. In bestimmten Fällen wäre es aber auch denkbar, die Lichtquelle an einer anderen Stelle, beispielsweise unter der Auflageplatte anzuordnen. Bei der Lichtquelle kann es sich beispielsweise um handelsübliche Leuchtdioden oder um andere Leuchten handeln.

Weitere Vorteile können erreicht werden, wenn die Auflageplatte zur Vermeidung einer elektrostatischen Aufladung an eine Erdungsleitung anschliessbar ist. Zu diesem Zweck ist die Arbeitsfläche mit einer elektrisch leitenden Beschichtung versehen oder auf andere Weise leitend ausgebildet.

Weitere Vorteile und Einzelmerkmale der Erfindung ergeben sich aus der nachstehenden Beschreibung eines Ausführungsbeispiels und aus den Zeichnungen. Es zeigen:
- Figur 1: einen Teilquerschnitt durch eine erfindungsgemässe Vor- richtung beim Einsatz in einem Die Bonder,
- Figur 2: eine Draufsicht auf die Vorrichtung gemäss Figur 1 ohne Substrat, und
- Figur 3: ein alternatives Ausführungsbeispiel einer erfindungs- gemässen Vorrichtung.

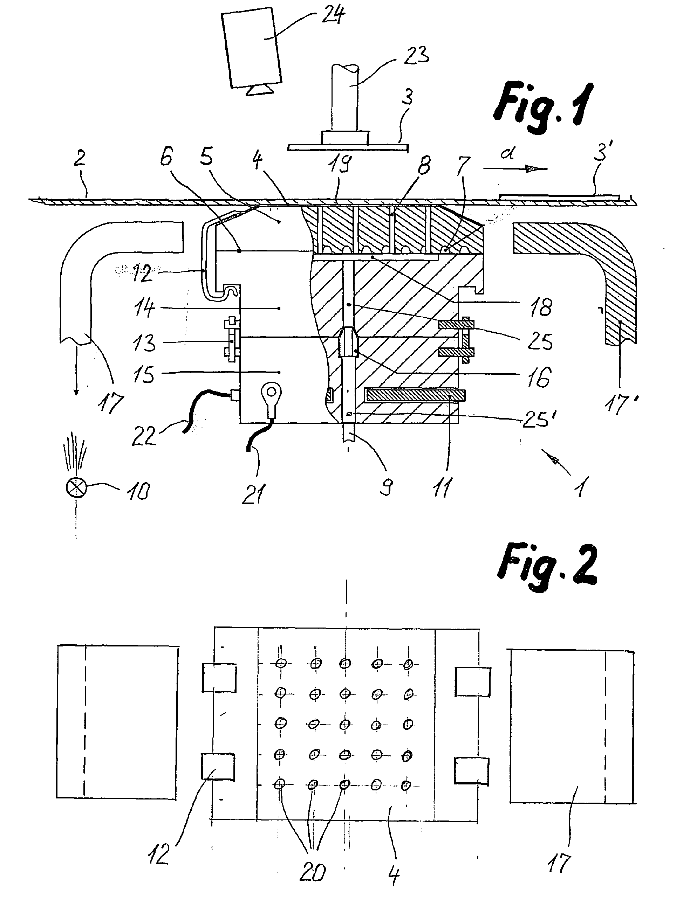

Wie aus den Figuren 1 und 2 ersichtlich ist, besteht eine insgesamt mit 1 bezeichnete Vorrichtung im wesentlichen aus einer Auflageplatte 5, beispielsweise aus Glas oder aus einem anderen transparenten oder teiltransparenten Material. Die Auflageplatte mit einem etwa rechteckigen Grundriss verfügt über eine Arbeitsfläche 4, die beispielsweise mit einer elektrisch leitenden Beschichtung 19 versehen sein kann. An den beiden Längsseiten ist die Auflageplatte 5 leicht angeschrägt. Diese Anschrägung erleichtert den Einlauf bzw. den Auslauf des in Pfeilrichtung a linear bewegten Substrats. Auf der Rückseite 6 der Auflageplatte 5 ist eine lichtreflektierende Struktur 7 in der Form einer Mehrzahl von napfförmigen Vertiefungen angeordnet. Die Auflageplatte ist ausserdem durchsetzt von mehreren Unterdruckkanälen 8, welche an Öffnungen 20 in der Arbeitsfläche 4 enden.

Die Auflageplatte 5 ruht auf einer Plattenbasis 14 und ist mit Hilfe von Klemmen 12 lösbar mit dieser verbunden. Diese Klemmen aus Metall dienen im Übrigen auch der Erdung der Arbeitsfläche. Die Plattenbasis besteht aus einem Wärme leitenden Material wie z.B. aus Stahl. Im Zentrum ist eine Bohrung 25 angeordnet, die auf der Seite der Auflageplatte in eine Verteilkammer 18 mündet. Die Verteilkammer erfasst dabei sämtliche Unterdruckkanäle 8 in der Auflageplatte 5. Die Verteilkammer 18 ist im Übrigen so angeordnet, dass verschiedene Auflageplatten 5 mit einer unterschiedlichen Anordnung von Unterdruckkanälen 8 aufgesetzt werden können.

Die Plattenbasis 14 ruht ihrerseits auf einem Sockel 15, der aus dem gleichen Material wie die Plattenbasis bestehen kann. Die lösbare Verbindung zwischen dem Sockel 15 und der Plattenbasis 14 besteht beispielsweise aus einer seitlichen Verriegelung 13. Auch der Sockel 15 verfügt über eine Bohrung 25', wobei mit Hilfe einer Zentrierhülse 16 eine zentrische Ausrichtung auf die Bohrung 25 in der Plattenbasis 14 erreicht wird. Die Bohrung 25' ist an eine Unterdruckleitung 9 angeschlossen, die zu einer Unterdruckquelle führt. Im Sockel 15 ist eine Heizvorrichtung 11 beispielsweise in der Form von mehreren Heizpatronen angeordnet. Diese Heizvorrichtung ist über eine Stromversorgungsleitung 22 an eine Stromquelle angeschlossen. Selbstverständlich könnte auch noch ein Thermostat vorgesehen sein, mit dessen Hilfe eine bestimmte Arbeitstemperatur eingehalten werden kann. Eine Erdungsleitung 21 sorgt dafür, dass sich die Auflageplatte nicht elektrostatisch aufladen kann.

Die Beleuchtung der Arbeitsfläche 4 mittels Durchlicht erfolgt über je eine Lichtquelle 10 auf beiden Seiten der Auflageplatte 5. Das Licht dieser Lichtquelle wird über gekrümmte Lichtwellenleiter 17 seitlich in die Auflageplatte 5 eingespeist. Das Licht wird dabei an der Struktur 7 reflektiert und gleichmässig nach oben gegen die Arbeitsfläche 4 gerichtet. Selbstverständlich könnte die Intensität der Lichtquelle und/oder die Wellenlänge des Lichts ebenfalls steuerbar sein.

Über die Arbeitsfläche 4 ist beim Ausführungsbeispiel ein Substrat 2 in der Form eines Streifens geführt, der taktweise in Pfeilrichtung a bewegt werden kann. Über eine hier nicht näher dargestellte Pickvorrichtung mit einem Pickarm 23 wird ein Chip präzise über dem Substrat 2 positioniert, auf das Substrat abgesetzt und mit dem Substrat verklebt. Zur Positionierung dient ein Bilderkennungssystem in der Form einer Kamera 24, welche in der Lage ist, Positioniermarken auf der Rückseite des Substrats 2 zu erkennen. Ersichtlicherweise wird dabei das Substrat 2 mit dem an den Unterdruckkanälen 8 anliegenden Unterdruck unverrückbar auf der Arbeitsfläche 4 fixiert, während über die Heizvorrichtung 11 der Arbeitsfläche Wärme zugeführt wird, welche den Klebevorgang begünstigt.

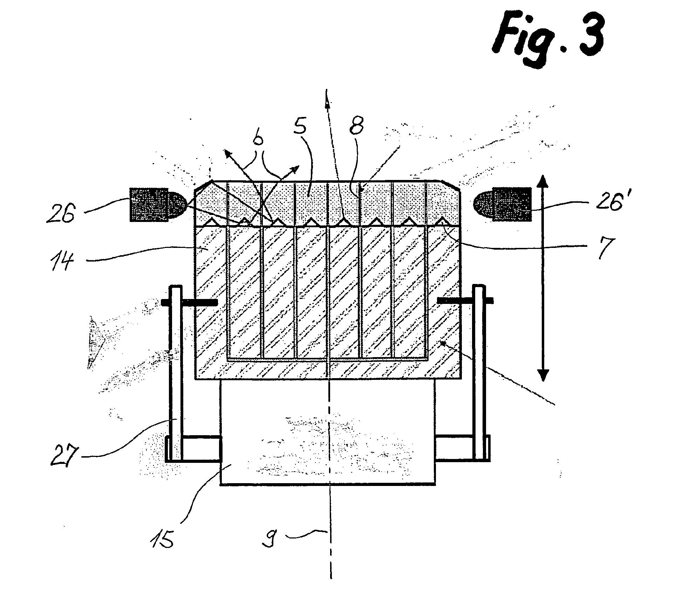

Bei der Vorrichtung gemäss Figur 3 ist die Auflageplatte 5 beispielsweise aus Glaskeramik fest mit der Plattenbasis 14 verklebt. Die seitliche Einspeisung von Licht erfolgt nicht mit Hilfe von Lichtwellenleitern, sondern durch Lichtquellen 26, 26', welche unmittelbar seitlich einstrahlen. Die strahlungsreflektierende Struktur 7 besteht aus pyramidenartigen bzw. kegelartigen Vertiefungen. Der Strahlungsverlauf ist durch die Strahlungspfeile b angedeutet. Wie daraus ersichtlich ist, kann dabei auch Licht durch interne Totalreflexion an der Arbeitsfläche 4 reflektiert und auf die Struktur 7 zurückgeworfen werden.

Bei diesem Ausführungsbeispiel ist der Sockel 15 ebenfalls über lösbare Klemmen 27 mit der Plattenbasis 14 verbunden. Im Sockel 15 ist eine hier nicht näher dargestellte Heizvorrichtung eingebaut.

Die einzelnen Unterdruckkanäle 8 in der Auflageplatte 5 münden nicht in eine gemeinsame Verteilkammer, sondern sie sind direkt in der Plattenbasis 14 fortgesetzt und münden dann in eine gemeinsame Unterdruckleitung 9.

## Patentansprüche

1. Vorrichtung (1) zum Fixieren eines flächigen Objektes, insbesondere eines Substrats (2) auf einer Arbeitsfläche (4) mittels Unterdruck, mit einer wenigstens teilweise transparenten Auflageplatte (5), deren eine Seite die Arbeitsfläche bildet und die eine im Abstand zur Arbeitsfläche angeordnete Rückseite (6) aufweist, wobei die Auflageplatte Unterdruckkanäle (8) aufweist, die an eine Unterdruckleitung (9) anschliessbar sind und die in die Arbeitsfläche münden, **gekennzeichnet durch** eine strahlungsreflektierende Struktur (7), die im Bereich der Rückseite der Auflageplatte (5) angeordnet ist und wenigstens eine Lichtquelle (10), deren Strahlung derart seitlich in die Auflageplatte (5) einspeisbar ist, dass die Arbeitsfläche unter Einwirkung der strahlungsreflektierenden Struktur homogen beleuchtbar ist.

2. Vorrichtung nach Anspruch 1, **gekennzeichnet durch** eine Heizvorrichtung (11), welche zum Heizen der Arbeitsfläche (4) mit der Auflageplatte (5) in Wirkverbindung steht.

3. Vorrichtung nach Anspruch 1 oder 2, **dadurch gekennzeichnet, dass** die Auflageplatte (5) aus Glaskeramik besteht.

4. Vorrichtung nach einem der Ansprüche 1 bis 3, **dadurch gekennzeichnet, dass** die reflektierende Struktur (7) aus Vertiefungen auf der Rückseite (6) der Auflageplatte (5) besteht.

5. Vorrichtung nach einem der Ansprüche 1 bis 4, **dadurch gekennzeichnet, dass** die Auflageplatte (5) auf einer Plattenbasis (14) aufliegt.

6. Vorrichtung nach einem der Ansprüche 1 bis 3 und 5, **dadurch gekennzeichnet, dass** die reflektierende Struktur (7) auf der der Auflageplatte (5) zugewandten Oberfläche der Plattenbasis angeordnet ist.

7. Vorrichtung nach Anspruch 5 oder 6, **dadurch gekennzeichnet, dass** die Auflageplatte (5) lösbar mit der Plattenbasis (14) verbunden ist.

8. Vorrichtung nach Anspruch 5 oder 6, **dadurch gekennzeichnet, dass** die Auflageplatte (5) mit der Plattenbasis (14) verklebt ist.

9. Vorrichtung nach Anspruch 7 oder 8, **dadurch gekennzeichnet, dass** die Plattenbasis (14) ihrerseits lösbar auf einem Sockel (15) aufliegt, wobei im Sockel eine Heizvorrichtung (11) angeordnet ist.

10. Vorrichtung nach einem der Ansprüche 1 bis 8, **dadurch gekennzeichnet, dass** die Auflageplatte (5) mit einer heizbaren Beschichtung versehen ist.

11. Vorrichtung nach einem der Ansprüche 1 bis 10, **dadurch gekennzeichnet, dass** die Lichtquelle (10) auf der Seite der Auflageplatte (5) auf einer Ebene zwischen der Arbeitsfläche (4) und der strahlungsreflektierenden Struktur (7) angeordnet ist.

12. Vorrichtung nach einem der Ansprüche 1 bis 10, **dadurch gekennzeichnet, dass** die Strahlung der Lichtquelle (10) über wenigstens einen Lichtwellenleiter (17, 17') auf die Seite der Auflageplatte (5) in einer Ebene zwischen der Arbeitsfläche (4) und der strahlungsreflektierenden Struktur (7) in die Auflageplatte (5) einspeisbar ist.

13. Vorrichtung nach einem der Ansprüche 1 bis 12, **dadurch gekennzeichnet, dass** die Auflageplatte (5) zur Vermeidung einer elektrostatischen Aufladung eine elektrisch leitende Arbeitsfläche aufweist, die an eine Erdungsleitung (21) anschliessbar ist.

14. Vorrichtung nach Anspruch 4, **dadurch gekennzeichnet, dass** die Vertiefungen eine inhomogene Verteilung und/oder eine inhomogene Struktur aufweisen.

15. Vorrichtung nach Anspruch 5 und einem der Ansprüche 6 bis 14, **dadurch gekennzeichnet, dass** in der Plattenbasis (14) eine Verteilkammer (18) angeordnet ist, in welche mehrere zur Arbeitsfläche führende Unterdruckkanäle (8) münden.

## Claims

1. Apparatus (1) for fixing a planar object, in particular a substrate (2), on a working area (4) by means of vacuum, having an at least partly transparent bearing plate (5), one side of which forms the working area and which has a rear side (6), which is arranged at a distance from the working area, the bearing plate having vacuum channels (8) which can be connected to a vacuum line (9) and which open into the working area, **characterized by** a radiation-reflecting structure (7) which is arranged in the region of the rear side of the bearing plate (5), and by at least one light source (10), the radiation of which can be fed laterally into the bearing plate (5) in such a way that the working area can be illuminated homogeneously with the action of the radiation-reflecting structure.

2. Apparatus according to claim 1, **characterized by** a heating apparatus (11), which is operatively connected to the bearing plate (5) for the purpose of heating the working area (4).

3. Apparatus according to claim 1 or 2, **characterized in that** the bearing plate (5) is composed of glass ceramic.

4. Apparatus according to one of claims 1 to 3, **characterized in that** the reflecting structure (7) comprises depressions on the rear side (6) of the bearing plate (5).

5. Apparatus according to one of claims 1 to 4, **characterized in that** the bearing plate (5) bears on a plate base (14).

6. Apparatus according to one of claims 1 to 3 and 5, **characterized in that** the reflecting structure (7) is arranged on that surface of the plate base which faces the bearing plate (5).

7. Apparatus according to claim 5 or 6, **characterized in that** the bearing plate (5) is releasably connected to the plate base (14).

8. Apparatus according to claim 5 or 6, **characterized in that** the bearing plate (5) is adhesively bonded to the plate base (14).

9. Apparatus according to claim 7 or 8, **characterized in that** the plate base (14) for its part bears releasably on a pedestal (15), a heating apparatus (11) being arranged in the pedestal.

10. Apparatus according to one of claims 1 to 8, **characterized in that** the bearing plate (5) is provided with a heatable coating.

11. Apparatus according to one of claims 1 to 10, **characterized in that** the light source (10) is arranged on the side of the bearing plate (5) on a plane between the working area (4) and the radiation-reflecting structure (7).

12. Apparatus according to one of claims 1 to 10, **characterized in that** the radiation from the light source (10) can be fed via at least one optical waveguide (17, 17') onto the side of the bearing plate (5) in a plane between the working area (4) and the radiation-reflecting structure (7) into the bearing plate (5).

13. Apparatus according to one of claims 1 to 12, **characterized in that** the bearing plate (5) has an electrically conductive working area, which can be connected to an earthing line (21), for the purpose of avoiding an electrostatic charging.

14. Apparatus according to claim 4, **characterized in that** the depressions have an inhomogeneous distribution and/or an inhomogeneous structure.

15. Apparatus according to claim 5 and one of claims 6 to 14, **characterized in that** a distribution chamber (18) is arranged in the plate base (14), into which distribution chamber open a plurality of vacuum channels (8) leading to the working area.

## Revendications

1. Dispositif (1) pour la fixation d'un objet en deux dimensions, en particulier d'un substrat (2) sur une surface de travail (4) au moyen de dépression, comprenant une plaque d'appui (5) au moins en partie transparente, dont un côté forme la surface de travail et qui comporte une face arrière (6) disposée à distance de la surface de travail, la plaque d'appui présentant des canaux de dépression (8) qui peuvent être raccordés à une conduite de dépression (9) et qui débouchent dans la surface de travail, **caractérisé par** une structure (7) réfléchissant le rayonnement disposé dans la zone de la face arrière de la plaque d'appui (5), et au moins une source de lumière (10), dont le rayonnement peut être injecté latéralement dans la plaque d'appui (5) de telle sorte que la surface de travail peut être éclairée de façon homogène sous l'effet de la structure réfléchissant le rayonnement.

2. Dispositif selon la revendication 1, **caractérisé par** un dispositif de chauffage (11) qui est en liaison active avec la plaque d'appui (5) pour le chauffage de la surface de travail (4).

3. Dispositif selon la revendication 1 ou 2, **caractérisé en ce que** la plaque d'appui (5) est en vitrocérame.

4. Dispositif selon l'une quelconque des revendications 1 à 3, **caractérisé en ce que** la structure (7) réfléchissante est constituée de cavités sur la face arrière (6) de la plaque d'appui (5).

5. Dispositif selon l'une quelconque des revendications 1 à 4, **caractérisé en ce que** la plaque d'appui (5) repose une base de plaque (14).

6. Dispositif selon l'une quelconque des revendications 1 à 3 et 5, **caractérisé en ce que** la structure (7) réfléchissante est disposée sur la surface, tournée vers la plaque d'appui (5), de la plaque de base.

7. Dispositif selon la revendication 5 ou 6, **caractérisé en ce que** la plaque d'appui (5) est reliée de façon amovible à la base de plaque (14).

8. Dispositif selon la revendication 5 ou 6, **caractérisé en ce que** la plaque d'appui (5) est collée avec la base de plaque (14).

9. Dispositif selon la revendication 7 ou 8, **caractérisé en ce que** la base de plaque (14) repose pour sa part de façon amovible sur un socle (15), un dispositif de chauffage (11) étant disposé dans le socle.

10. Dispositif selon l'une quelconque des revendications 1 à 8, **caractérisé en ce que** la plaque d'appui (5) est dotée d'un revêtement chauffant.

11. Dispositif selon l'une quelconque des revendications 1 à 10, **caractérisé en ce que** la source de lumière (10) est disposée sur le côté de la plaque d'appui (5) sur un plan entre la surface de travail (4) et la structure (7) réfléchissant le rayonnement.

12. Dispositif selon l'une quelconque des revendications 1 à 10, **caractérisé en ce que** le rayonnement de la source de lumière (10) peut être injecté au moyen d'au moins un guide d'ondes optiques (17, 17') sur le côté de la plaque d'appui (5) dans un plan entre la surface de travail (4) et la structure (7) réfléchissant le rayonnement dans la plaque d'appui (5).

13. Dispositif selon l'une quelconque des revendications 1 à 12, **caractérisé en ce que** la plaque d'appui (5) comporte pour éviter une décharge électrostatique une surface de travail électroconductrice qui peut être raccordée à une ligne de mise à la terre (21).

14. Dispositif selon la revendication 4, **caractérisé en ce que** les cavités présentent une répartition inhomogène et/ou une structure inhomogène.

15. Dispositif selon la revendication 5 et l'une quelconque des revendications 6 et 14, **caractérisé en ce que** dans la base de plaque (14) est disposée une chambre de répartition (18), dans laquelle débouchent plusieurs canaux de dépression (8) aboutissant à la surface de travail.
